## Europäisches Patentamt
## European Patent Office
## Office européen des brevets

(19)

(11) Veröffentlichungsnummer: **0 105 087**
**B1**

(12) # EUROPÄISCHE PATENTSCHRIFT

(45) Veröffentlichungstag der Patentschrift:
**23.09.87**

(51) Int. Cl.⁴: **H 02 J 13/00, H 03 H 17/02**

(21) Anmeldenummer: **83105834.2**

(22) Anmeldetag: **14.06.83**

(54) **Digitalfilter für Fernsteuerempfänger, insbesondere für Rundsteuerempfänger.**

(30) Priorität: **01.10.82 CH 5804/82**

(43) Veröffentlichungstag der Anmeldung:
**11.04.84 Patentblatt 84/15**

(45) Bekanntmachung des Hinweises auf die Patenterteilung:
**23.09.87 Patentblatt 87/39**

(84) Benannte Vertragsstaaten:
**AT BE DE FR**

(56) Entgegenhaltungen:
**CH-A-559 983**
**CH-A-607 467**
**DE-A-2 708 074**
**DE-A-3 034 584**

**L. RABINER u.a.: "Theory and application of digital signal processing", 1975, Seiten 40-50, Prentice-Hall Inc., Englewood Cliffs, US.**

(73) Patentinhaber: **ZELLWEGER USTER AG, Wilstrasse 11, CH- 8610 Uster (CH)**

(72) Erfinder: **Müller, Beat, Witellikerstrasse 10, CH- 8702 Zollikon- Dorf (CH)**

(74) Vertreter: **Dipl.- Phys.Dr. Manitz Dipl.- Ing., Dipl.- Wirtsch. Finsterwald Dipl.- Chem.Dr. Heyn Dipl.- Phys. Rotermund Morgan, B.Sc.(Phys.), Robert- Koch- Strasse 1, D-8000 München 22 (DE)**

EP 0 105 087 B1

## Beschreibung

In konventionellen elektronischen oder elektromechanischen Fernsteuerempfängern, wie sie beispielsweise in Rundsteuersystemen zur Anwendung gelangen, werden für die empfängerseitige Rückgewinnung der Fernsteuersignale bzw. Fernsteuerbefehle, welche zusammen mit der Netzspannung, deren Harmonischen und allenfalls weiteren Störfrequenzen dem Fernsteuerempfänger eingangsseitig zugeführt werden, vorzugsweise Kaskaden von LC- oder aktiven RC-Filtern zweiter Ordnung angewendet.

Solche Filter sind dabei als schmale Bandpässe ausgebildet. Der Gütefaktor Q liegt üblicherweise bei etwa 30, damit das relativ schwache Fernsteuersignal von beispielsweise etwa 1 bis 8 Volt aus dem zum Teil sehr beträchtliche Störsignale führenden Niederspannungsnetz von beispielsweise 220 V 50 Hz für die Auswertung herausgefiltert werden kann. Vergleiche hiezu beispielsweise CH-A-607 467.

Als Störfrequenzen treten die Netzspannung mit 220 V und ihre Harmonischen mit Spannungen von normalerweise bis etwa 15 Volt und gelegentlich sogar noch etwas mehr auf. Siehe hiezu die Publikation VDEW: Empfehlung für die Frequenzplanung bei Frequenz-Rundsteueranlagen, Verlags- und Wirtschaftsgesellschaft der Elektrizitätswerke mbH, 6 Frankfurt (Main) 1970.

Es ist schon ein Verfahren und eine Vorrichtung zur Fernübertragung von Signalen vorgeschlagen worden, bei welchem ein Abtastfilter in der Form eines Digitalbandpasses vorgesehen ist, siehe CH-A-559 983.

Weiterhin ist ein elektronischer Rundsteuerempfänger vorgeschlagen worden, siehe DE-A-2 708 074, ohne dass darin jedoch nähere Angaben über das Digitalfilter gemacht werden.

Bei der Anwendung eines Digitalfilters, unter Benutzung eines Mikrocomputers als Rechenwerk für einen Rundsteuerempfänger treten Schwierigkeiten auf, wenn die von der Anwendung her geforderten Filtereigenschaften wirtschaftlich gelöst werden sollen. Insbesondere tritt die Schwierigkeit auf, dass mit den wirtschaftlich günstigen 8-Bit-Rechenwerken (Mikrocomputer) ein passendes Digitalfilter nicht ohne besondere Massnahmen realisiert werden kann.

Unter Berücksichtigung der von der Anwendung her verlangten Dynamik kann dann ein bekanntes analoges Filter für Fernsteuerempfänger nicht ohne weiteres "nach allgemein bekannten Regeln in ein digitales Filter transformiert werden". Durch eine filterinterne Anhebung des Nutzsignals, das heisst des Fernsteuersignals, neigt nämlich ein 8-Bit-Rechenwerk bereits zum Übersteuern (Overflow), und dies selbst wenn noch kein Störsignal auftritt. Im Hinblick auf die praktisch vorkommenden Nutzsignal-/Störsignal-Verhältnisse allein würde zwar ein 8-Bit-Rechenwerk für die Signalverarbeitung eine gerade noch ausreichende Dynamik aufweisen. In der Praxis zeigt sich jedoch, dass die erwähnte Signalanhebung die einwandfreie Arbeitsweise des Filters in Frage stellt. Die dadurch hervorgerufene Übersteuerung innerhalb der Filterstufen ist auch eine Folge der aus praktischen Erfordernissen verlangten Gütefaktoren Q von etwa 30 und der in der Praxis verlangten Abtastraten (Verhältnis von Abtastfrequenz des Eingangssignales und der Resonanzfrequenz) von mindestens 2.

Der vorliegenden Erfindung liegt daher die Aufgabe zugrunde, ein für Fernsteuerempfänger, insbesondere Rundsteuerapparate geeignetes Digitalfilter zu schaffen, bei welchem trotz Verwendung eines eine Dynamik von nur 8 Bit aufweisenden Rechenwerkes (Mikrocomputer) die genannten Übersteuerungen (Overflow) nicht mehr auftreten und wobei eine für die vorgesehene Anwendung geeignete Durchlasscharakteristik des Digitalfilters verwirklicht ist.

Zur Lösung dieser Aufgabe dienen die in den Ansprüchen niedergelegten Massnahmen. Im folgenden wird die Erfindung anhand der Zeichnung beispielsweise erläutert, dabei zeigt

Fig. 1 eine Filterstruktur in Anlehnung an: "Theory and Application of Digital Signal Processing" (Rabbiner/Gold), Prentice Hall International Inc. London 1975, Seite 41 und folgende;

Fig. 2 eine schematische Darstellung einer digitalen Filterstufe 2. Ordnung mit Erläuterungen der einzelnen Symbole und der zugehörigen Übertragungsfunktion;

Fig. 3 eine Durchlasscharakteristik einer ersten Filterstufe;

Fig. 4 eine Durchlasscharakteristik einer zweiten Filterstufe;

Fig. 5 eine Gesamtdurchlasscharakteristik über beide Stufen gemäss Fig. 3 und Fig. 4 in Kaskade;

Fig. 6 eine Gesamtdurchlasskurve mit Nullstellen bei + und - 10 % unterhalb bzw. oberhalb der gewünschten Empfangsfrequenz;

Fig. 7 eine schematische Darstellung von kaskadierten Filterstufen zweiter Ordnung.

Zum Stande der Technik wird ausser den bereits genannten Publikationen auch noch verwiesen auf das Buch "Halbleiter-Schalttechnik" (Tietze/Schenk) 5. Auflage, Springer-Verlag Berlin 1980 sowie Dissertation Nr. 5 645/1976 ETH Zürich: Probleme der Realisierung digitaler Filter, (F. Bonzanigo) sowie auf die Publikation "Theory and design of digital filters" Electronic Engineering May 1977, Morgan Grampian Limited, Calderwood Str. London SE 18 2 BP.

Für die Anwendung eines digitalen Filters in einem Fernsteuerempfänger, insbesondere in einem Rundsteuerempfänger ist es sehr wichtig, dass die für die einwandfreie Arbeitsweise erforderliche Durchlasscharakteristik mit äusserster Wirtschaftlichkeit verwirklicht werden kann. Dabei wird es wohl preislich immer von Vorteil sein, ein Rechenwerk mit möglichst geringer Dynamik (z. B. nur 8 Bit) einsetzen zu können (z. B. Mikrocomputer mit 8-Bit-Rechenwerk).

Durch die Stabilisierung der Taktfrequenz, sei es beispielsweise mittels eines bekannten Quarzoszillators oder durch Bindung der Taktfrequenz an eine Referenzfrequenz, beispielsweise an die Netzfrequenz, kann mit sehr geringem Aufwand eine ausreichende Frequenzstabilität auch über eine lange Gebrauchsdauer erzielt

2

werden.

Die Filtercharakteristik eines solchen Digitalfilters kann in einem eingeschränkten, jedoch für die Praxis ausreichenden Frequenzbereich grundsätzlich gleich gestaltet werden wie bei den bisher üblichen analogen Filtern, d.h. man erreicht gleichen Amplitudengang und gleichen Phasengang wie bei diesen.

Für die Ausführung eines solchen Filters mittels eines Rechenwerkes (Mikrocomputer), beispielsweise nach DE-A-2 708 074, müsste jedoch berücksichtigt werden, dass die digitale Filterung mit genügend geringem Aufwand an Rechenzeit im Rechenwerk realisiert werden muss, weil das System ja zeitecht betrieben werden muss.

Zudem ist anzustreben, dass bereits ein Rechenwerk aus der Klasse der preisgünstigsten "Ein-Chip"-Mikrocomputer geeignet ist. Ein preisbestimmender Faktor ist dabei die sogenannte Bit-Zahl des Mikrocomputers. Im vorliegenden Fall ist darunter die Länge der verwendeten Daten-Wörter gemeint, d.h. die Anzahl der binären Stellen pro Zahl. Üblich sind heute die in Tabelle 1 zusammengefassten Werte.

**Tabelle 1:**

| 4 Bit | Zahlenbereich | $0 - 15 (2^4)$ | Dynamik | 24 db |
|-------|---------------|----------------|---------|-------|
| 8 Bit | " | $0 - 255 (2^8)$ | " | 48 db |
| 12 Bit | " | $0 - 4\,095 (2^{12})$ | " | 72 db |
| 16 Bit | " | $0 - 65\,535 (2^{16})$ | " | 96 db |

Die Bit-Zahl definiert die Rechendynamik des Mikrocomputers bzw. Rechenwerkes.

Bezüglich der Rechengeschwindigkeit muss ebenfalls darauf geachtet werden, dass ein kostengünstiges Standard-Produkt zur Anwendung kommen kann. Dies bedeutet, dass für das digitale Filter Minimalstrukturen zum Einsatz kommen sollten, welche für die Filterung einen möglichst geringen Rechenaufwand benötigen, also wenig Additionen, wenig Multiplikationen und wenig Speichermanipulationen. Solche Minimalstrukturen sind rekursive Filter in einer "direkten Form", wie sie in der bereits zitierten Publikation von Rabbiner/Gold auf Seite 41 und folgende, beschrieben sind.

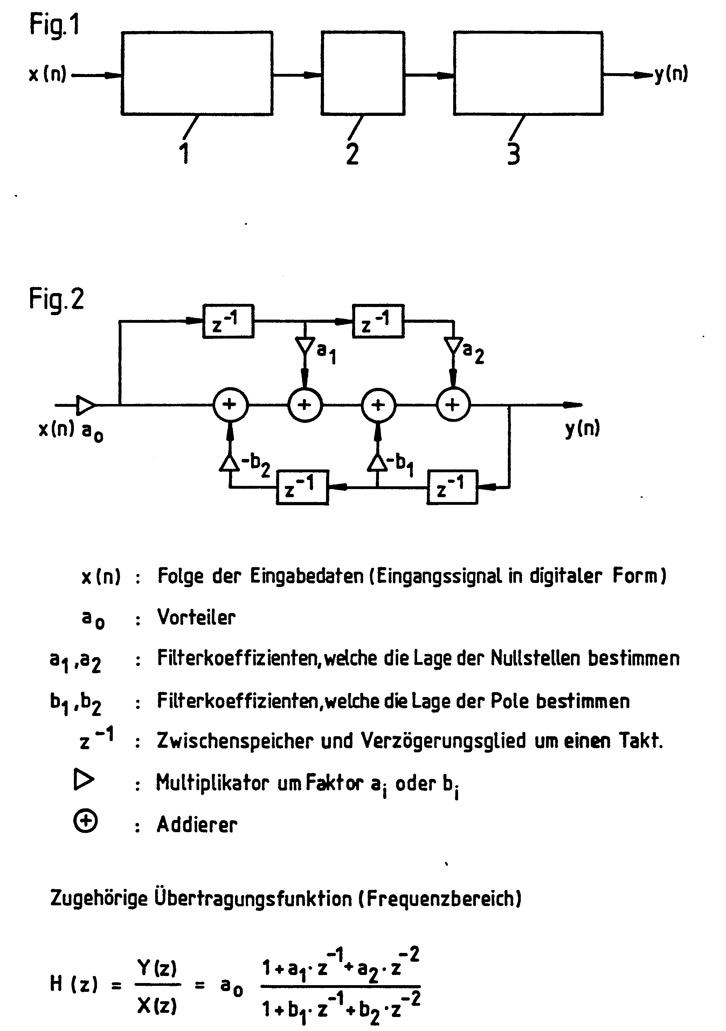

Der Fachmann wird durch eine der bekannten Transformationstechniken, wie sie in der vorstehend erwähnten Publikation und auch in der bereits erwähnten Publikation von Tietze/Schenk beschrieben sind, beispielsweise die bilineare Transformation, die charakteristischen Koeffizienten des analogen Filters so transformieren, dass er die Koeffizienten des digitalen Filters mit ähnlichen Eigenschaften erhält. Das digitale Filter stimmt dann bezüglich seiner Durchlasscharakteristik bis zur halben Abtastfrequenz weitgehendst mit dem analogen überein. Dann verwirklicht er diese Koeffizienten in einer geeigneten Filterstruktur gemäss den zitierten Literaturstellen, z. B. nach Fig. 1 und Fig. 2 der beiliegenden Zeichnung. In Fig. 1 bedeutet

$x(n)$ = Eingangszahlenfolge (abgetastetes und digitalisiertes Eingangssignal)
$y(n)$ = Ausgangszahlenfolge
1 = eine 1. digitale Filterstufe zweiter Ordnung
2 = ein digitaler Teiler (Divisionsglied)
3 = eine 2. digitale Filterstufe zweiter Ordnung.

Die Figur 2 zeigt eine Struktur einer digitalen Filterstufe 2. Ordnung.

Diese konventionelle Methode wird zwar zum Ziele führen bezüglich der Durchlasscharakteristik, sie hat aber den Nachteil, dass das entstehende digitale Filter eine wesentlich grössere Dynamik des einzusetzenden Rechenwerkes erfordert als dies vom gegebenen Nutzsignal-/Störsignal-Verhältnis her notwendig wäre. Es zeigt sich nämlich, dass als Folge der relativ hohen Gütefaktoren Q, welche für Filter in Rundsteuerapplikationen notwendig sind, die einzelnen Filterstufen eine entsprechend hohe Verstärkung der Resonanzfrequenz $f_g$ (d.h. in diesem Fall des Nutzsignals) aufweisen. Bei einer Filterstufe 2. Ordnung mit einer Güte Q von 30 gilt der in Tabelle 2 dargestellte Zusammenhang.

**Tabelle 2:**

| Abtastfrequenz fs | ungefähre Verstärkung bei $f_g$ |
|-------------------|--------------------------------|
| $10 \times f_g$ | 100 |
| $6 \times f_g$ | 55 |
| $4 \times f_g$ | 40 |

Diese Verstärkung $v_g$ bei der Frequenz $f_g$ berechnet sich nach folgender Formel:

$$v_g = |X(e^{j\omega g})| = \frac{Z_1 \cdot Z_2}{P_1 \cdot P_2} \text{ (I) für eine Filterstufe 2. Ordnung}$$

dabei sind $Z_i = |e^{j\omega g} - z_i|$ $Z_i \triangleq Z_1, Z_2$

und $P_i = |e^{j\omega g} - p_i|$ $P_i \triangleq P_1, P_2$

$z_i$ sind die Nullstellen der Z-Übertragungsfunktion des Filters
$p_i$ sind die Pole der Z-Übertragungsfunktion des Filters

0 105 087

Siehe hiezu auch die erwähnte Publikation Rabbiner/Gold Kapitel 2,18.

Tendenziell ist festzustellen, dass die Resonanzfrequenzverstärkung vg der Filterstufe mit Zunahme der Filtergüte Q und mit Zunahme der Abtastrate (Verhältnis der Abtastfrequenz $f_s$ zur Resonanzfrequenz $f_g$) ebenfalls zunimmt.

Bei einer Abtastrate von ca. 6 bis 10 hat man bei einer Filtergüte von 30 mit einer Anhebung des Nutzsignals um den Faktor 55 bis 100 zu rechnen. Dies bedeutet, dass ein minimales Nutzsignal, das vernünftigerweise mit mindestens ± 2 Recheneinheiten (eine Recheneinheit entspricht der Zahl "1") auf die erste Filterstufe gegeben wird, am Ausgang mit ± 110 bis ± 200 Recheneinheiten erscheint. Bei höheren Nutzsignalpegeln, welche in der Praxis durchaus vorkommen können, wird der Bedarf an Rechendynamik des Rechenwerkes entsprechend grösser, wie dies die nachfolgende Tabelle 3 zeigt.

**Tabelle 3:**

| Nutzsignal | Recheneinheiten am Filter | | erforderliche |
| | Eingang | Ausgang | Dynamik |
| --- | --- | --- | --- |
| 1 V | ± 2 | ± 110 bis ± 220 | 8 bis 9 bit |
| 2 V | ± 4 | ± 220 bis ± 440 | 9 bis 10 bit |
| . | | | |
| . | | | |
| . | | | |
| 8 V | ± 16 | ± 880 bis ± 1760 | 11 bis 12 bit |

Nimmt man nun an, dass in bestehenden Niederspannungsnetzen das Signal-/Störspannungs-Verhältnis für irgendeine über längere Zeit anstehende Störspannung, wie z. B. eine Netzharmonische, den Wert 1/20 kaum unterschreitet, so sieht man, dass auch unter Umständen, wo mehrere Störspannungen gleichzeitig auftreten, eine Rechenauflösung von 1/256, wie sie durch ein 8-Bit-Rechenwerk gegeben ist, eigentlich ausreichen sollte, dies falls es gelingt, die innere Verstärkung der Filterstufen zu eliminieren. Dabei wird jedoch angenommen, dass die Spannung der Grundfrequenz selber durch ein geeignetes analoges Vorfilter bereits ausreichend reduziert wird. Dies ist mit bekannten einfachen Mitteln möglich, und ein Vorfilter ist bekanntlich wegen der Mehrdeutigkeit digitaler Filter ohnehin erforderlich.

Es ergibt sich dann folgende Problematik. Die Aufgabe der digitalen Filterung von Rundsteuersignalen mittels preisgünstigen Rechenwerken (8-Bit-Mikrocomputer) und möglichst integriertem 8-Bit-Analog-Digital-Wandler in einer "Ein-Chip"-Ausführung und mittels minimaler Filterstrukturen ist nicht lösbar, wenn man einen bestehenden analogen schmalen Bandpass nach allgemein bekannten Regeln in einen digitalen schmalen Bandpass transformiert. Zufolge interner Anhebung des Nutzsignals neigt das 8-Bit-Rechenwerk zum Übersteuern (Overflow), und zwar schon wenn noch keine Störfrequenzen auftreten.

Aus der Sicht der Nutzsignal-/Störsignal-Verhältnisse allein würde ein 8-Bit-Rechenwerk aber eine genügende Dynamik aufweisen.

Der Erfindung liegt nun folgender Lösungsgedanke zugrunde: Gegeben durch die Forderung nach einer hohen Güte des schmalen Bandfilters und nach einem geringen Rechenaufwand wählt man eine geeignete Filterstruktur, z. B. ein sogenanntes rekursives Filter vierter Ordnung, realisiert als Kaskade von zwei rekursiven Filtern zweiter Ordnung gemäss Figur 1. Der Problematik der hohen Resonanzfrequenzverstärkung der einzelnen Stufen begegnet man dabei durch das gezielte Plazieren von Nullstellen in die Nähe der Resonanzfrequenz.

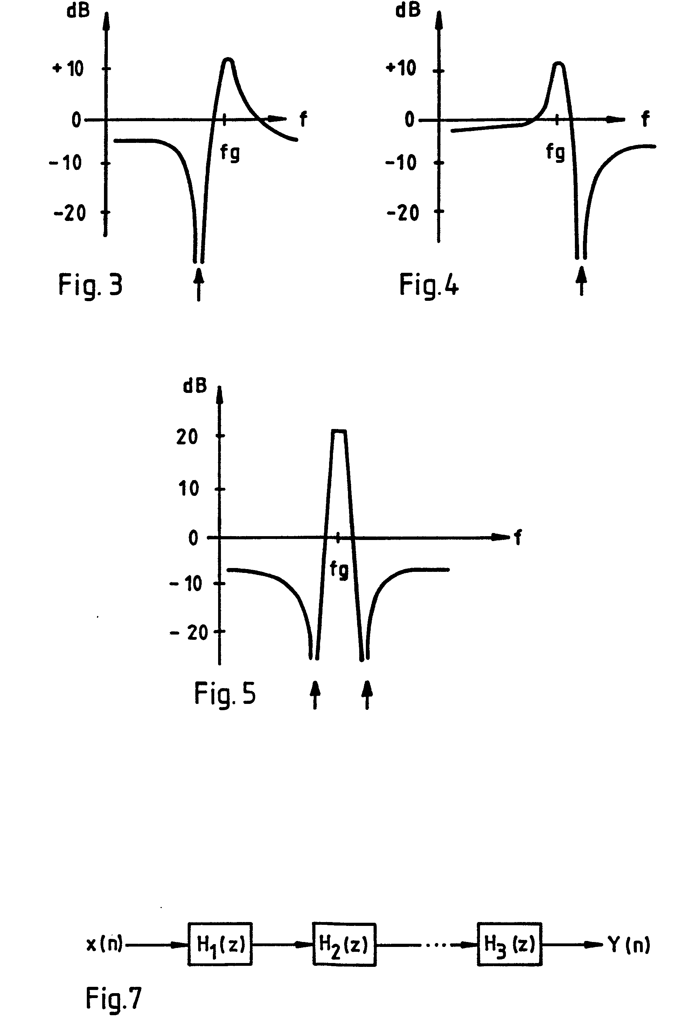

Der ersten Stufe verleiht man eine Durchlasscharakteristik etwa gemäss Figur 3, und der zweiten Stufe verleiht man eine Durchlasscharakteristik etwa gemäss Figur 4. Über beide Stufen in Kaskade ergibt sich dann eine Gesamtdurchlasscharakteristik etwa gemäss Figur 5. In den Figuren 3, 4 und 5 markieren die Pfeile die Lage der Nullstellen.

Ein Nullstellen-Paar kommt in der bilinearen Transformation, wie sie früher erwähnt wurde, auf die Frequenzen f = 0 und f = $f_s$/2 zu liegen und bewirkt damit ein Sperren des Filters bei Frequenzen gegen 0 und gegen $f_s$/2 resp. ganzzahlige Mehrfache von $f_s$/2. (n = 1, 2, 3,..; siehe hiezu zitierte Literaturstelle "Theory and Application of Digital Signal Processing" (Rabbiner/Gold) S. 221.).

Legt man diese Nullstellen in die Nähe der Resonanzfrequenz $f_g$, so bekommt das Filter einen endlichen Durchlassbereich bei f = 0 und bei f = n · $f_s$/2.

Dieser Nachteil muss in Kauf genommen werden. Er wird durch das bereits erwähnte bekannte einfache Vorfilter behoben. Untersuchungen haben gezeigt, dass bei günstiger Wahl der Nullstellen dieser Nachteil wesentlich weniger ins Gewicht fällt als der Vorteil, der sich dadurch ergibt, dass die Faktoren $Z_1$ und $Z_2$ in der früher erwähnten Formel (I) soweit verkleinert werden, dass für die Resonanzfrequenzverstärkung $v_g$ pro Filterstufe zweiter Ordnung akzeptable Werte herauskommen.

Legt man die der Frequenz $f_g$ benachbarten Nullstellen bei f = $f_g$ ± 10 %, so ergibt sich eine Durchlasscharakteristik eines solchen digitalen Filters gemäss Figur 5.

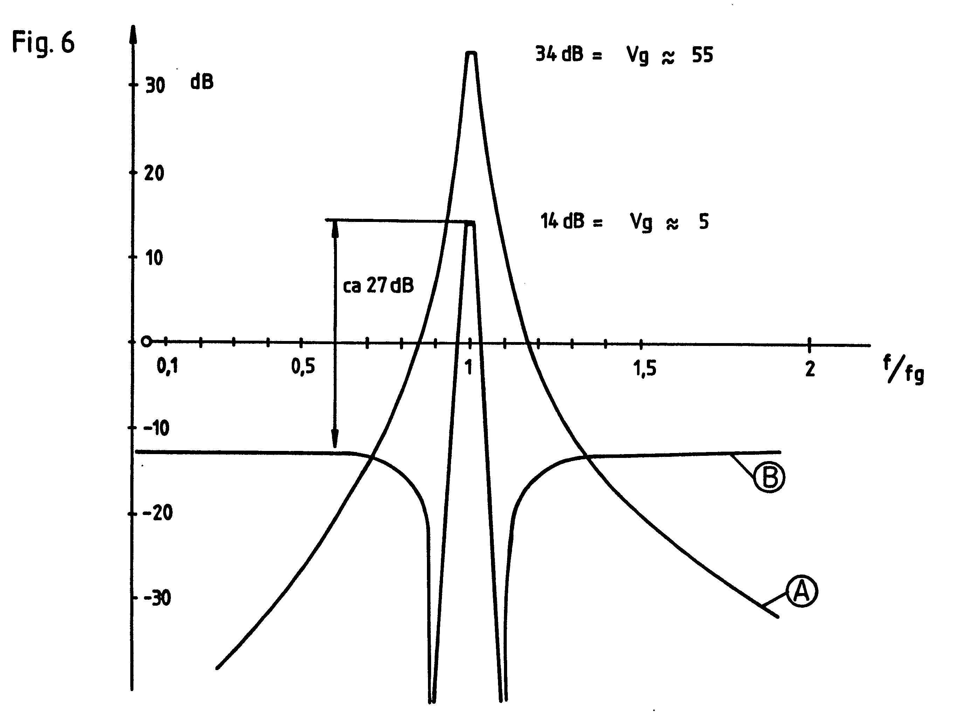

In Fig. 6 zeigt die Kurve A den Amplitudengang eines Filters gemäss Fig. 1, wobei die beiden Filterstufen je eine Nullstelle bei f/$f_g$ = 0 und f/$f_g$ = $f_s$/(2 · $f_g$) aufweisen, wie es sich aus der bilinearen Transformation ergibt. Beide Stufen besitzen eine Resonanzfrequenzverstärkung von 34 dB (Faktor 55). Der Teiler besitzt ein

4

Teilverhältnis von 1 : 55 (- 34 dB). Damit wird die maximale Signalanhebung der ersten Stufe auf den Wert 1 zurückskaliert.

Die Kurve B in Figur 6 zeigt den Amplitudengang eines Filters (gemäss Fig. 1), wobei die erste Filterstufe eine Nullstelle 10 % unterhalb der Resonanzfrequenz und die zweite Filterstufe eine Nullstelle 10 % oberhalb der Resonanzfrequenz besitzt. Der Amplitudengang der ersten Stufe wird in Fig. 3 dargestellt, derjenige der 2. Stufe in Fig. 4. Mit diesen verschobenen Nullstellen wird erreicht, dass die Resonanzfrequenzverstärkung pro Filterstufe nur noch ca. 14 dB (Faktor 5) im Gegensatz zu 34 dB (Faktor 55) zum oben erwähnten Filter hat. Dies wirkt sich für die erforderliche Dynamik des Rechenwerkes günstig aus. Der Teiler zwischen den Filterstufen besitzt in diesem Falle ein Teilverhältnis von 1: 5. Das Filter besitzt im Nah-Selektivbereich gleich gute oder bekommt sogar leicht bessere Eigenschaften, im Weitabbereich bekommt es allerdings eine endliche Dämpfung von ca. - 27 dB, bezogen auf die Resonanzfrequenz.

Zur Wahl der Lage der Nullstellen im Frequenzgang empfehlen sich folgende Überlegungen:

1. Akzeptable Resonanzfrequenzverstärkung je nach der Dynamik des zur Verwendung vorgesehenen Rechenwerkes

2. Akzeptabler Verlauf der Durchlasscharakteristik im Weitabbereich im Hinblick auf die Anforderungen an das bereits erwähnte Vorfilter.

Dabei ist in Erwägung zu ziehen, dass die Resonanzfrequenzverstärkung $v_g$ abnimmt je näher die Nullstellen an die Resonanzfrequenz gelegt werden. Allerdings nimmt dabei die Dämpfung im Weitabbereich ab, und die Ansprüche an das Vorfilter werden dadurch höher. Zur Erleichterung der Wahl optimaler Parameter wird auf die in der nachfolgenden Tabelle 4 dargestellten Zusammenhänge verwiesen.

**Tabelle 4**:     2 Filterstufen je 2. Ordnung
Güte ca. 30, Abtastrate ca. 6

| Nullstellen | $v_g$ pro Stufe (absolut) | Dämpfung bei f = 0 |
|---|---|---|
| $f_g \pm 5\,\%$ | ca. 2,5 (+ 8 db) | - 15 db |
| $f_g \pm 10\,\%$ | 5 (+ 14 db) | - 27 db |
| $f_g \pm 20\,\%$ | 12 (+ 21 db) | - 39 db |
| $f_g \pm 40\,\%$ | 25 (+ 28 db) | - 53 db |

Verwendet man ein Rechenwerk mit 8-Bit-Dynamik, d.h. entsprechend 48 db und rechnet man mit Nutzsignalen von $\pm$ 1 bis $\pm$ 16 Einheiten Eingangsdynamik, entsprechend 30 db, so wird ersichtlich, dass die Nullstellen innerhalb eines Bereiches $f_g \pm 20\,\%$ liegen müssen. $v_g$ + Dynamik des Eingangssignals: 21 db + 30 db = 51 db. Anderseits sollte man im Sperrbereich des Filters eine relative Dämpfung (bezogen auf den Durchlassbereich) von ca. -30 db erreichen. Damit ergibt sich gemäss Beispiel in Tabelle 4 ein Mindestabstand der Nullstellen von $f_g \pm 10\,\%$ für eine Dämpfung von - 27 db im Weitabbereich (z. B. f = o). Die fehlenden - 3 db können durch das ohnehin erforderliche analoge Vorfilter erzeugt werden.

Damit ergeben sich in der Praxis optimale Lagen der Nullstellen zwischen $f = f_g \pm 20\,\%$ und $f = f_g \pm 10\,\%$. Dies gilt im Falle einer Abtastrate von 6 und einem Gütefaktor Q von etwa 30.

Ein beispielsweise für einen Rundsteuerempfänger geeignetes Digitalfilter gemäss der Erfindung hat beispielsweise folgende in Tabelle 5 dargestellte charakteristische Werte.

**Tabelle 5**:

| Rundsteuerfrequenz | 167 Hz | ($\doteq$ 10. 16 2/3 Hz) |
|---|---|---|
| 1. Störfrequenz | 150 Hz | ($\doteq$ 3. Netzharmonische) |
| 2. Störfrequenz | 184 Hz | (= Fernsteuerfrequenz einer benachbarten Anlage) |

Das Verhältnis der Störfrequenzen zur Nutzfrequenz beträgt dabei 150/167 und 184/167, was den Faktoren 0,9 und 1,1 entspricht. Diese Verhältnisse sind insofern günstig, weil die Hauptstörfrequenzen gerade bei $f_g \pm 10$ % liegen. Da man die so eingeführten Nullstellen im Bereich von etwa $f_g \pm 10$ bis $f_g \pm 20$ % frei wählen kann, erweist es sich als besonders günstig, diese genau auf die hauptsächlichen Störfrequenzen zu legen, was zur Folge hat, dass das Filter wesentlich unempfindlicher wird, gerade gegen diese hauptsächlichen Störfrequenzen. Man erreicht durch diese Massnahme also zusätzlich noch eine markante technische Verbesserung des Filters.

In der Praxis kann ein digitales Filter für Fernsteuerempfänger mit Nullstellen in der Übertragungsfunktion wie folgt gebaut werden:

1. Es wird ein geeignetes Rechenwerk genommen, das die erforderliche Mindestbitzahl von z. B. 8 Bit aufweist. Vorzugsweise kann ein Microcomputer verwendet werden. Damit das vorgefilterte analoge Signal dem Rechenwerk direkt zugeführt werden kann, ist es sinnvoll einen "One Chip Microcomputer" mit eingebauten Analog-Digital Wandler einzusetzen. (z. B. MC 6805R2 von Motorola Semiconductor Products Inc., 3501 Bluestein Blvd. Austin, Texas 78721)

2. Es wird eine geeignete Filterstruktur gewählt. Vorzugsweise werden Filterstufen zweiter Ordnung kaskadiert. (Gemäss Fig.7)

5

0 105 087

Für die einzelne Stufe wird ebenfalls eine geeignete Struktur gewählt. (z. B. gemäss Fig. 2)

3. Für jede Filterstufe werden nun die Filterkoeffizienten berechnet. Entsprechende Methoden, wie die Koeffizienten eines gegebenen analogen Filters, in die korrespondierenden Koeffizienten des digitalen Filter transformiert werden können, sind bekannt (z. B. die bereits erwähnte bilineare Transformation). Zudem könnten auch Methoden angewandt werden, um selektive Stufen zweiter Ordnung, gegebener Güte Q, direkt als digitales Filter zu entwerfen.

Wesentlich ist nun, dass für jene Filterkoeffizienten, welche die Lage der Nullstellen bestimmen, diejenigen Werte eingesetzt werden, welche Nullstellen (maximale Dämpfung) im frequenzabhängigen Übertragungsverhalten derart erzeugen, dass alle die in der Beschreibung angegebenen Erfordernisse an die Filterstufe, erfüllt werden. (Genügende Selektivität und akzzeptable Resonanzfrequenzverstärkung.)

Diese Filterkoeffizienten gemäss Fig. 2 berechnen sich wie folgt:

$a_1 = -2 \cdot \cos [2 \cdot \pi \cdot (f_g + \Delta f) / fs]$

$a_2 = 1$

$\Delta f$ = frequenzmässiger Abstand der Nullstellen zu $f_g$

Damit ist ein geeignetes digitales Filter für Fernsteuerempfänger grundsätzlich entworfen. In weiteren Schritten muss es nur noch nach den bekannten Regeln der Kunst optimiert werden (Skalierung, Limitierung der Wortlänge der Koeffizienten z. B.). Dies geschieht nach den Anweisungen in den erwähnten Literaturstellen.

4. Das digitale Filter wird dann nach den Anleitungen der Rechenwerkhersteller ins Rechenwerk hineinprogrammiert und in allenfalls auch vorhandene andere Programme, die vorzugsweise zum Auswerten des Filterausganges dienen, eingebettet.

**Patentansprüche**

1. Digitalfilter für Fernsteuerempfänger, insbesondere Rundsteuerempfänger mit einem Einchip-Mikrocomputer zum Ausfiltern der Rundsteuerimpulse,
dadurch <u>gekennzeichnet</u>,
daß der Mikrocomputer durch einen 8-Bit-Mikrocomputer mit einer im wesentlichen lediglich dem Nutz-/Störsignalverhältnis angepaßten Dynamik gebildet ist, und daß das Filter durch zwei kaskadierte rekursive Filter zweiter Ordnung realisiert ist, in deren Durchlaßbereich zwei Nullstellen in der Nähe der Resonanzfrequenz ($f_g$) plaziert sind, um die Resonanzverstärkung ($V_g$) der Filterstufen so stark zu reduzieren, daß der Mikrocomputer für die übersteuerungsfreie Verarbeitung der zugeführten Signale ausreicht.

2. Digitalfilter nach Anspruch 1, dadurch <u>gekennzeichnet</u>, daß die Nullstellen in einem Frequenzbereich von ± 50 % um die Resonanzfrequenz ($f_g$) liegen.

3. Digitalfilter nach Anspruch 2, dadurch <u>gekennzeichnet</u>, daß die Nullstellen in einem Frequenzbereich von ± 20 % um die Resonanzfrequenz ($f_g$), vorzugsweise zwischen $f_g$ ± 20 % und $f_g$ ± 10 %, liegen.

4. Digitalfilter nach Anspruch 2 oder 3, dadurch <u>gekennzeichnet</u>, daß die Nullstellen wenigstens annähernd auf Frequenzen liegen, welche ganzzahlige Vielfache von Netzfrequenz-Subharmonischen sind.

5. Digitalfilter nach Anspruch 4, dadurch <u>gekennzeichnet</u>, daß sowohl die Nutzsignalfrequenz als auch die beiden Nullstellenfrequenzen je ganzzahlige Vielfache der gleichen Subharmonischen der Netzfrequenz sind.

6. Digitalfilter nach Anspruch 5, dadurch <u>gekennzeichnet</u>, daß die frequenzmäßig untere Nullstellenfrequenz und die frequenzmäßig obere Nullstellenfrequenz des Digitalfilters aufeinanderfolgende ganzzahlige Vielfache der gleichen Subharmonischen der Netzfrequenz sind.

**Claims**

1. Digital filter for remote control receivers, in particular for ripple control receivers with a one chip microcomputer for filtering out the ripple control pulses, characterised in that the microcomputer is formed by an 8-bit microcomputer with a dynamic range, which is matched substantially only to the signal/noise ratio; and in that the filter is realised by two cascaded recursive filters of the second order in the transmission range of which two zero points are placed in the region of th resonant frequency ($f_g$) in order to reduce the resonance amplification ($V_g$) of the filter stages so greatly that the microcomputer is sufficient for overflow-free processing of the supplied signals.

2. Digital filter in accordance with claim 1, characterised in that the zero points lie in a frequency range of + 50 % about the resonant frequency ($f_g$).

3. Digital filter in accordance with claim 2, characterised in that the zero points lie in a frequency range of ± 20 % around the resonant frequency ($f_g$), preferably between $f_g$ ± 10 % and $f_g$ ± 10 %.

4. Digital filter in accordance with claim 2 or claim 3, characterised in that the zero points lie at least approximately at frequencies which are integral multiples of subharmonics of the mains frequency.

5. Digital filter in accordance with claim 4, characterised in that both the wanted signal frequency and also the two zero point frequencies are each integral multiples of the same subharmonic of the mains frequency.

6

6. Digital filter in accordance with claim 5, characterised in that the frequency-wise lower zero point frequency and the frequency-wise upper zero point frequency of the digital filter are sequential integral multiples of the same subharmonic of the mains frequency.

## Revendications

1. Filtre numérique pour récepteur de télécommande, en particulier récepteur de commande circulaire, comportant un microcalculateur sur une plaquette unique en vue du filtrage des impulsions de commande circulaire, caractérisé en ce que le microcalculateur est constitué par un microcalculateur 8 bits avec une dynamique adaptée essentiellement uniquement au rapport signal/bruit, et en ce que le filtre est réalisé par deux filtres récursifs du second ordre en cascade, dans la plage de transmission duquel deux zéros sont placés à proximité de la fréquence de résonance ($f_g$), afin de réduire l'amplification de résonance ($V_g$) des étages de filtre si fortement que le microcalculateur suffit pour le traitement sans surmodulation des signaux appliqués.

2. Filtre numérique selon yla revendication 1, caractérisé en ce que les zéros se trouvent dans une plage de fréquences de $\pm$ 50 % autour de la fréquence de résonance ($f_g$).

3. Filtre numérique selon la revendication 2, caractérisé en ce que les zéros se trouvent dans une plage de fréquences de $\pm$ 20 % autour de la fréquence de résonance ($f_0$), de préférence entre $f_g \pm$ 20 % et $f_g$ + 10 %.

4. Filtre numérique selon la revendication 2 ou 3, caractérisé en ce que les zéros se trouvent au moins approximativement en des fréquences qui sont des multiples entiers de sousharmoniques de la fréquence du secteur.

5. Filtre numérique selon la revendication 9, caractérisé en ce qu'aussi bien la fréquence du signal utile que les deux fréquences des zéros sont chacune des multiples entiers du même sous-harmonique de la fréquence du secteur.

6. Filtre numérique selon la revendication 5, caractérisé en ce que la valeur de la fréquence du zéro inférieur et la valeur de la fréquence du zéro supérieur du filtre numérique sont des multiples entiers du même sous-harmonique de la fréquence du secteur.

**Fig.1**

$x(n) \longrightarrow$ [1] $\longrightarrow$ [2] $\longrightarrow$ [3] $\longrightarrow y(n)$

**Fig.2**

$x(n)\ a_0 \qquad\qquad y(n)$

| $x(n)$ | : | Folge der Eingabedaten (Eingangssignal in digitaler Form) |
|---|---|---|
| $a_0$ | : | Vorteiler |
| $a_1, a_2$ | : | Filterkoeffizienten, welche die Lage der Nullstellen bestimmen |
| $b_1, b_2$ | : | Filterkoeffizienten, welche die Lage der Pole bestimmen |
| $z^{-1}$ | : | Zwischenspeicher und Verzögerungsglied um einen Takt. |
| $\triangleright$ | : | Multiplikator um Faktor $a_i$ oder $b_i$ |
| $\oplus$ | : | Addierer |

Zugehörige Übertragungsfunktion (Frequenzbereich)

$$H(z) = \frac{Y(z)}{X(z)} = a_0\ \frac{1 + a_1 \cdot z^{-1} + a_2 \cdot z^{-2}}{1 + b_1 \cdot z^{-1} + b_2 \cdot z^{-2}}$$

1

0 105 087

Fig. 3

Fig. 4

Fig. 5

Fig. 7

3

Fig. 6